# EUROPEAN PATENT APPLICATION

(11) **EP 2 573 208 A1**
(43) Date of publication of application: **27.03.2013**
(21) Application number: 11783581.9
(22) Date of filing: 18.05.2011
(51) Int. Cl.: C23C 28/00, C23C 8/12, C23C 8/42, C25D 5/48, C25D 7/00, C25D 7/08

(54) **ELECTROLYTICALLY SILVER PLATED AND/OR ELECTROLYTICALLY SILVER ALLOY PLATED ARTICLE HAVING OXIDE LAYER ON SURFACE**

(30) Priority: 20.05.2010 JP 2010116020
(71) Applicant: JX Metals Trading Co., Ltd., Tokyo 104-0045 (JP)
(72) Inventor: IMORI, Toru, Kitaibaraki-shi Ibaraki 319-1535 (JP); KINASE, Takashi, Takatsuki-shi Osaka 569-0036 (JP); OKA, Ryusuke, Takatsuki-shi Osaka 569-0036 (JP)
(74) Representative: Schwabe - Sandmair - Marx
(86) International application number: PCT/JP2011/061414
(87) International publication number: WO 2011/145647

(57) **Abstract**

The object of the present invention is to provide a silver plated and/or a silver alloy plated article with high productivity, high reflectance in the visible light range, and excellent sulfidizing resistance. The present invention provides a silver electroplated and/or silver alloy electroplated article having an oxidation layer on its surface, wherein a silver plating layer and/or silver alloy plating layer is formed on a substrate by silver electroplating and/or silver alloy electroplating, and then subjected to oxidation treatment to form an oxidation layer on the surface thereof. The thickness of the oxidation layer formed on the surface of the plating layer is 0.05 µm or more.

## Description

### TECHNICAL FIELD

The present invention relates to a silver electroplated and/or silver alloy electroplated article having an oxidation layer on its surface.

### BACKGROUND ART

Because of their high optical reflectance (hereunder abbreviated as "reflectance."), silver films are widely used in reflective plates for downlighting, and in the reflective surfaces of LED (light-emitting diode) packages. Because in LED packages the input current to the LED is increased until a certain light output is obtained, the life of the LED is greatly impacted when the reflectance of the reflective surfaces which affects the resulting light output is low. Therefore, in high-output LED packages used for main lighting such as residential lighting, automobile headlights and the like, the reflectance of the reflective surfaces and the spectrum characteristics are critical factors affecting product performance, and the reflectance in particular should be as high as possible. Specifically, silver films are required to have high reflectance in the total wavelength range (370 to 700 nm) of visible light including near-ultraviolet, and methods have been proposed for increasing reflectance as in Patent Document 1.
However, in the method described in Patent Document 1 the silver film is manufactured by an electroless plating process, so productivity is poor because 10 to 30 minutes is required even to form a common film thickness of 200 nm. Other problems include high running costs because the bath used in plating is short-lived.

Since silver is an active substance, moreover, the surface of a silver coating is liable to discoloration from chloridation and the like, and turns brown or blue-black from corrosion in atmospheres containing sulfur in particular. In addition, when a metal other than silver or a metal oxide or sulfide is present in a layer under the silver coating, these substances are likely to diffuse into the silver coating, moving to the surface of the silver coating, affecting its optical reflectance and detracting from performance in each case. Taking the example of the aforementioned LED package for example, if a silver coating is formed as an optically reflective part on the copper that forms the lead frame, the copper will diffuse into the silver coating and detract from the reflectance when it reaches the surface of the silver coating.
A technique that has been proposed for preventing such diffusion into the silver coating is to provide a diffusion preventing layer of any of the platinum group metals palladium, rhodium, platinum, ruthenium and iridium or an alloy of these before forming the silver plating (Patent Document 2).
However, no effective techniques have been developed for improving the optical reflectance properties of silver coatings and preventing the drop in optical reflectance that occurs from discoloration in atmospheres containing sulfur in particular, and such improvements would be desirable from the standpoint of promoting application to white light sources in particular.

### Prior Art Documents

### Patent Documents

Patent Document 1: Japanese Patent Publication No. 2000-155205 A
Patent Document 2: Japanese Patent Publication No. 2007-258514 A

### Summary of Invention

### Problems that the Invention is to Solve

It is an object of the present invention, which was developed to resolve the issues described above, to provide a silver plated and/or a silver alloy plated article with high productivity, high reflectance in the visible light range, and excellent sulfidizing resistance.
It is another object of the present invention to provide an optically reflective material and a light-emitting diode device having as a reflecting surface a film with high productivity, high reflectance in the visible light range, and excellent sulfidizing resistance.

### Means for Solving the Problems

The inventors arrived at the present invention as a result of exhaustive research after discovering that a plated article having a high reflectance of about 80 to 99% in the visible light range could be obtained by forming a silver plating layer and/or silver alloy plating layer by electroplating and then forming an oxidation layer on the outermost surface of this plating layer, with the thickness of the oxidation layer being preferably 0.05 µm or more. It was also discovered that excellent sulfidizing resistance was obtained by forming the oxidation layer.
In the present invention, the oxidation layer is a layer comprising oxygen diffused in silver or a silver alloy.

That is, the present invention is as follows.
(1) A silver electroplated and/or silver alloy electroplated article having an oxidation layer on its surface, wherein a silver plating layer and/or silver alloy plating layer is formed on a substrate by silver electroplating and/or silver alloy electroplating, and then subjected to oxidation treatment to form an oxidation layer on the surface thereof.
(2) The silver electroplated and/or silver alloy electroplated article having an oxidation layer on its surface according to (1) above, wherein the thickness of the oxidation layer formed on the surface of the plating layer is 0.05 µm or more.
(3) The silver electroplated and/or silver alloy electroplated article having an oxidation layer on its surface according to (1) or (2) above, wherein the silver alloy plating layer includes at least one metal selected from the group consisting of zinc, gallium, indium, germanium, tin, antimony, gold, bismuth, palladium, platinum, rhodium, iridium and ruthenium in an amount of 0.01 to 5 wt%.
(4) The silver electroplated and/or silver alloy electroplated article having an oxidation layer on its surface according to any one of (1) to (3) above, wherein the silver plating and/or silver alloy electroplating layer having the oxidation layer has an L value of 70 or more, an a value of -1.0 to 1.0 and a b value of -1 to 4 in the Lab colorimetric system in a three-dimensional coordinate.
(5) The silver electroplated and/or silver alloy electroplated article having an oxidation layer on its surface according to any one of (1) to (4) above, wherein the oxidation treatment is performed at 50 to 600°C in an oxidizing gas atmosphere.
(6) The silver electroplated and/or silver alloy electroplated article having an oxidation layer on its surface according to any one of (1) to (4) above, wherein the oxidation treatment is wet treatment by boiling in water or wet treatment using an oxidizing agent.
(7) The silver electroplated and/or silver alloy electroplated article having an oxidation layer on its surface according to any one of (1) to (6) above, wherein the silver electroplated and/or silver alloy electroplated article having an oxidation layer on its surface is an optically reflective material.
(8) A light-emitting diode device having the optically reflective material according to (7) above.

### Advantageous Effects of Invention

With the present invention, a silver electroplated and/or silver alloy electroplated article can be provided with high productivity, high reflectance in the visible light range and excellent sulfidizing resistance. With the optically reflective material and light-emitting diode device of the present invention, it is possible to provide an optically reflective material and light-emitting dioide device with high productivity, high reflectance in the visible light range and excellent sulfidizing resistance.

### Mode for Carrying Out the Invention

In the silver electroplated and/or silver alloy electroplated article having an oxidation layer on its surface of the present invention, a silver plating layer and/or silver alloy plating layer is formed on a substrate by silver electroplating and/or silver alloy electroplating, after which oxidation treatment is performed to oxidize the silver and form an oxidation layer on the surface of the plating layer.
Productivity can be improved because the silver plating layer and/or silver alloy plating layer is formed by electroplating.

The substrate is not particularly limited as long as it is one that can be silver electroplated or silver alloy electroplated, and examples include copper, silver, nickel, tin, zinc and alloys of these and the like. When the substrate is copper, one strategy that is generally considered effective for preventing diffusion of copper from the substrate is to form a thick silver plating layer of 5 µm or more, but because an oxidation layer 0.5 µm or more thick is provided in the present invention, copper diffusion can be prevented even if the silver plating layer is 4 µm thick or less, and copper diffusion can even be prevented if the thickness is reduced to 3 µm. The exact mechanism is not known, but it may be that diffusion of the underlying copper is suppressed because crystal grain boundaries disappear or are eliminated by the amorphous structure of the oxidation film.

The surface roughness Ra of the substrate is preferably 0.5 µm or less. In this constitution, high reflectance can be achieved while minimizing the film thickness of the silver plating layer and silver alloy plating layer, thereby enhancing productivity. When the substrate surface is formed of nickel, the nickel preferably contains no sulfur. In this constitution, it is possible to obtain the same degree of reflectance as with a thick film and improve corrosion resistance using a thin silver plating layer and silver alloy plating layer.

The plating solution used for the silver electroplating and silver alloy electroplating can be any capable of forming a silver plating layer and silver alloy plating layer, and a known plating solution can be used.
The silver plating solution and silver alloy plating solution can be high-cyan baths or low-cyan baths, but a low-cyan bath is preferred for forming an oxidation layer by heat treatment. It is also not necessary to add a brightening agent. Because the concentration of a brightening agent used in electroplating cannot be measured by current analytical techniques, it is effectively impossible to precisely assay, maintain and control the concentration of the brightening agent in the plating solution. It is therefore easier to maintain a constant quality during manufacturing with a bath that contains no brightening agent.

The thickness of the silver plating layer and silver alloy plating layer is preferably a total of 0.5 to 8 µm.
A plated article having a silver electroplating layer formed on a substrate and an oxidation layer formed on the surface of the electroplating layer can achieve high reflectance and productivity even if the silver plating layer is thin. The thickness of the silver plating layer may also be 4 µm or more.
In a plated article comprising an oxidation layer formed on the surface of a silver alloy electroplating layer formed on a substrate, the silver alloy plating film itself has the effect of preventing dispersal of copper from the plated article, and a loss of reflectance can be prevented even if the plating film thickness is small. It has been discovered that this effect can be obtained by including at least one metal selected from gallium, indium, germanium, tin, antimony, gold, bismuth, palladium, platinum, rhodium, iridium and ruthenium in an amount of 0.01 to 5 wt%. The preferred content is 0.1 to 1 wt%.
The thickness of the silver alloy plating layer is preferably 0.1 to 8 µm, more preferably 0.5 to 6 µm.

The oxidation treatment may be wet oxidation treatment or dry oxidation treatment in an oxidizing gas atmosphere such as air, O₂ gas or ozone gas. Wet oxidation treatment is preferred from the standpoint of mass production, since large-volume, uniform treatment is possible with wet oxidation treatment. However, dry treatment is preferred from an environmental standpoint since it produces no waste liquid. Dry treatment also facilitates process control because it requires no liquid control.
Wet oxidation methods than can be used include a method of boiling in water and a method of treatment in an aqueous solution with a suitable amount of an oxidizing agent added thereto, but the method of treatment in an aqueous solution with a suitable amount of an oxidizing agent added thereto is preferred from the standpoint of productivity. Nitric acid, nitrate salts such as sodium nitrate, hydrogen peroxide, manganese peroxide, potassium permanganate, potassium persulfate, sodium hypochlorite or the like can be used as the oxidizing agent.

For the dry oxidizing treatment, the silver plating layer and silver alloy plating layer are preferably subjected to heat treatment for 30 seconds or more at a temperature of 50 to 600°C or preferably 100 to 400°C in an oxidizing gas atmosphere. With such a manufacturing method, the crystal grain boundaries are reduced, making it possible to increase reflectance in the total wavelength range (370 to 700 nm) of visible light including near-ultraviolet, which is close to the excitation wavelength of a blue LED. When such dry oxidation treatment is to be performed, the electroplating treatment for manufacturing the silver plating layer and silver alloy plating layer is preferably performed with a low-cyan bath. The potassium cyanide concentration of a low-cyan bath silver alloy electroplating solution is preferably 0.1 to 10 g/L.

By making the surface of the silver plating layer or silver alloy plating layer into an oxidation layer, such oxidation treatment serves to inactivate the surface and thereby prevent discoloration due to sulfidizing or chloridation. The reflectance of the oxidation layer surface under visible light is equivalent to that obtained without oxidation treatment, eliminating concerns about a drop in reflectance, and there is also no loss of reflectance due to sulfidizing or chloridation.

The thickness of the formed oxidation layer is preferably 0.05 µm or more. Preferably it is 0.05 to 5 µm. Sulfidizing resistance is lowered when the thickness is below 0.05 µm.
A natural oxide film forms in the air on the surface of a silver plating film, but this is less than 0.05 µm thick. On the other hand, a layer containing oxygen dispersed to a depth of 0.05 µm or more is formed by oxidation treatment.

The surface of a silver plating or silver alloy plating film having an oxidation layer preferably has L = 70 or more, a = -1.0 to 1.0 and b = -1 to 4 in the Lab colorimetric system in three-dimensional coordinate. Within this range, the hue is equivalent to that of a silver film.

A silver plated and/or silver alloy plated article having this oxidation layer can be used as an optically reflective material, and an LED device can be manufactured using this silver plating layer or silver alloy plating layer having an oxidation layer as a reflective surface. The light emitted from the LED can be efficiently reflected using such an LED device. In this case, the LED device is preferably manufactured by forming a conductive film on the surface of a substrate, patterning the conductive film to form a circuit pattern, forming a copper plating layer on the circuit pattern, forming a nickel plating layer on the copper plating layer, and then forming a silver plating layer on the nickel plating layer.

### Examples

The present invention is explained in more detail below by means of examples.

### Example 1 and Comparative Example 1

Silver electroplating was performed on a copper substrate using the following silver plating bath under the following plating conditions.

### Silver Plating Bath

| | |
|---|---|
| Ag: | 2.5 g/L (potassium silver cyanide used as the Ag) |
| KCN: | 5 g/L |
| Plating temperature: | 25°C |
| Plating area: | 0.1 dm² (25 mn × 20 mm) |
| Material to be plated: | Copper plate |
| Current density: | 2A/dm² |

Next, oxidation treatment was performed as follows in Example 1 under the conditions shown in Table 1, and following oxidation treatment the film thickness and reflectance of the oxidation layer were measured before and after sulfidizing treatment. In Comparative Example 1 no oxidation treatment was performed, and the film thickness and reflectance of the oxidation layer were measured before and after sulfidizing treatment.

The film thickness of the silver plating film and/or silver alloy plating film was determined by fluorescence X-ray spectroscopy.

The results are shown in Table 1.

### Oxidation treatment:

Dry treatment was performed for 10 minutes in the air using a hot plate at a specific temperature.
To determine the thickness of the oxidation layer formed on the surface, SIMS analysis was performed from the surface, and the depth at which the etching rate changed and the oxygen measurement value leveled off after decreasing rapidly from the surface was given as the thickness of the oxidation layer.

### Sulfidizing test:

Since a hydrogen sulfide gas test in accordance with JIS H 8502 is dangerous because it uses hydrogen sulfide gas, the following commonly-performed test was used as a simply substitute test, and change in external appearance was evaluated as a measure of change in reflectance. In the table, this is indicated as "sulfidizing".

| | |
|---|---|
| Ammonium sulfide reagent: | 0.3% aqueous solution |
| Liquid temperature: | 25°C |
| Immersion time: | 5 minutes |

### Reflectance:

This was measured with a spectrophotometer (Shimadzu UV-2200) using a Ba sulfate powder standard at a wavelength of 550 nm. In general, a yellow LED light source with a wavelength of 550 nm is used to obtain a white color, and this light is further adjusted with a fluorescent substance. Reflectance was evaluated using the wavelength of the light source.

### Examples 2 to 3, Comparative Example 2

Plating was performed as in Example 1 but using the following silver alloy plating bath and plating conditions instead of silver electroplating and with the oxidation treatment temperatures given in Table 1 to obtain the plated articles of Examples 2 and 3, which were then evaluated as in Example 1.
Silver alloy plating was performed as in Comparative Example 1 but using the following silver alloy plating bath and plating conditions instead of silver electroplating to obtain the plated article of Comparative Example 2, which was then evaluated as in Comparative Example 1.

### Silver-Palladium Plating Bath

| | |
|---|---|
| Ag: | 2.5 g/L (using potassium silver cyanide as the Ag) |
| Pd: | 5.0 g/L (using palladium potassium cyanide) |
| KCN: | 5 g/L |
| Plating temperature: | 25°C |
| Plating area: | 0.1 dm² (25 mm × 20 mm) |
| Material to be plated: | Copper plate |
| Current density: | 2A/dm² |

The alloy compositions of the silver alloy plating films were determined from the strength of the resulting silver alloy plating.

### Example 4, Comparative Example 3

Plating was performed as in Example 1 but using the following silver alloy plating bath and plating conditions instead of silver electroplating and with the oxidation treatment temperature given in Table 1 to obtain the plated article of Example 4, which was then evaluated as in Example 1.
Silver alloy plating was performed as in Comparative Example 1 but using the following silver alloy plating bath and plating conditions instead of silver electroplating to obtain the plated article of Comparative Example 3, which was then evaluated as in Comparative Example 1.

### Silver-Ruthenium Plating Bath

| | |
|---|---|
| Ag: | 2.5 g/L (using potassium silver cyanide as the Ag) |
| Ru: | 5.0 g/L (using potassium ruthenium cyanide) |
| KCN: | 5 g/L |
| Plating temperature: | 25°C |
| Plating area: | 0.1 dm² (25 mm × 20 mm) |
| Material to be plated: | Copper plate |
| Current density: | 2A/dm² |

### Example 5, Comparative Example 4

Plating was performed as in Example 1 but using the following silver alloy plating bath and plating conditions instead of silver electroplating and with the oxidation treatment temperature given in Table 1 to obtain the plated article of Example 5, which was then evaluated as in Example 1.
Silver alloy plating was performed as in Comparative Example 1 but using the following silver alloy plating bath and plating conditions instead of silver electroplating to obtain the plated article of Comparative Example 4, which was then evaluated as in Comparative Example 1.

### Silver-Rhodium Plating Bath

| | |
|---|---|
| Ag: | 2.5 g/L (potassium silver cyanide used as the Ag) |
| Rh: | 5.0 g/L (using potassium rhodium cyanide) |
| KCN: | 5 g/L |
| Plating temperature: | 25°C |
| Plating area: | 0.1 dm² (25 mm × 20 mm) |
| Material to be plated: | Copper plate |
| Current density: | 2A/dm² |

### Example 6

Substituting wet treatment for the oxidation treatment of the silver plated article obtained in Example 1, the plated article of Example 6 was obtained as in Example 1 except that oxidation treatment was performed by immersing for 5 minutes at 80°C in an aqueous solution containing 50 g/L manganese peroxide and 40 g/L sodium hydroxide, and evaluated as in Example 1.

**Table 1**

| | Substrate | Plating | Alloy grade (%) | Plating thickness (µm) | Treatment method | Treatment temperature (°C) | Treatment time (minutes) | Surface oxidation film thickness before sulfidizing (µm) | Reflectance before sulfidizing (%) | Surface oxidation film thickness after sulfidizing (µm) | Reflectance after sulfidizing (%) |
|---|---|---|---|---|---|---|---|---|---|---|---|
| Example 1 | Cu | Ag | 0 | 4 | dry treatment | 300 | 10 | 0.2 | 90 | 0.2 | 70 |
| Comparative Example 1 | Cu | Ag | 0 | 4 | dry treatment | none | - | 0 | 90 | 0.2 | 56 |
| Example 2 | Cu | Ag-Pd | Pd 0.2 | 2 | dry treatment | 200 | 10 | 0.2 | 91 | 0.2 | 70 |
| Example 3 | Cu | Ag-Pd Pd | Pd 0.2 | 2 | dry treatment | 300 | 10 | 0.5 | 91 | 0.5 | 80 |
| Comparative Example 2 | Cu | Ag-Pd | Pd 0.2 | 2 | dry treatment | none | - | 0 | 91 | 0 | 58 |
| Example 4 | Cu | Ag-Ru | Ru 0.5 | 2 | dry treatment | 300 | 10 | 0.4 | 89 | 0.4 | 75 |
| Comparative Example 3 | Cu | Ag-Ru | Ru 0.5 | 2 | dry treatment | none | - | 0 | 88 | 0 | 58 |
| Example 5 | Cu | Ag-Rh | Rh.07 | 2 | dry treatment | 300 | 10 | 0.4 | 89 | 0.4 | 72 |
| Comparative Example 4 | Cu | Ag-Rh | Rh. 0.7 | 2 | dry treatment | none | - | 0 | 86 | 0 | 58 |
| Example 6 | Cu | Ag | 0 | 4 | wet treatment | 80 | 5 | 0.2 | 89 | 0.2 | 68 |

As shown by the examples, a drop in reflectance from sulfidizing can be prevented by adding oxidation treatment to the plating film surface. It is also shown that oxidation treatment does not detract from reflectance.
Because diffusion of copper from the material to be plated can be prevented when using a silver alloy, moreover, a drop in reflectance can be prevented even if the plating film thickness is thin.

## Claims

1. A silver electroplated and/or silver alloy electroplated article having an oxidation layer on its surface, wherein a silver plating layer and/or silver alloy plating layer is formed on a substrate by silver electroplating and/or silver alloy electroplating, and then subjected to oxidation treatment to form an oxidation layer on the surface thereof.

2. The silver electroplated and/or silver alloy electroplated article having an oxidation layer on its surface according to claim 1, wherein the thickness of the oxidation layer formed on the surface of the plating layer is 0.05 µm or more.

3. The silver electroplated and/or silver alloy electroplated article having an oxidation layer on its surface according to claim 1 or 2, wherein the silver alloy plating layer includes at least one metal selected from the group consisting of zinc, gallium, indium, germanium, tin, antimony, gold, bismuth, palladium, platinum, rhodium, iridium and ruthenium in the amount of 0.01 to 5 wt%.

4. The silver electroplated and/or silver alloy electroplated article having an oxidation layer on its surface according to any one of 1 to 3, wherein the silver plating and/or silver alloy electroplating layer having the oxidation layer has an *L* value of 70 or more, a *a* value of -1.0 to 1.0 and a *b* value of -1 to 4 in the Lab colorimetric system in a three-dimensional coordinate.

5. The silver electroplated and/or silver alloy electroplated article having an oxidation layer on its surface according to any one of claims 1 to 4, wherein the oxidation treatment is performed at 50 to 600°C in an oxidizing gas atmosphere.

6. The silver electroplated and/or silver alloy electroplated article having an oxidation layer on its surface according to any one of Claims 1 to 4, wherein the oxidation treatment is wet treatment by boiling in water or wet treatment using an oxidizing agent.

7. The silver electroplated and/or silver alloy electroplated article having an oxidation layer on its surface according to any one of claims 1 to 6, wherein the silver electroplated and/or silver alloy electroplated article having an oxidation layer on its surface is an optically reflective material.

8. A light-emitting diode device having the optically reflective material according to claim 7.
